# FASCICULE DE BREVET EUROPEEN

(11) **EP 1 660 895 B1**
(45) Date de publication et mention de la délivrance du brevet: **25.07.2018**
(21) Numéro de dépôt: 04786319.6
(22) Date de dépôt: 18.08.2004
(51) Int. Cl.: G01R 29/10

(54) **CHAMBRE ANECHOIQUE A OBSERVATION DIRECTE DU COMPORTEMENT ELECTROMAGNETIQUE D'UN OUTIL A ETUDIER**
REFLEXIONSARMER RAUM ZUR DIREKTEN BETRACHTUNG DES EMV-VERHALTENS EINER ZU UNTERSUCHENDEN EINRICHTUNG
ANECHOIC CHAMBER WITH DIRECT OBSERVATION OF THE ELECTROMAGNETIC BEHAVIOUR OF A TOOL TO BE STUDIED

(30) Priorité: 18.08.2003 FR 0309985
(43) Date de publication de la demande: 31.05.2006
(73) Titulaire: Microwave Vision, 91140 Villebon Sur Yvette (FR)
(72) Inventeur: GARREAU, Philippe, F-91540 Mennecy (FR); DUCHESNE, Luc, F-91470 Angervilliers (FR); IVERSEN, Per, Olav, 30068 Marietta (US); GANDOIS, Arnaud, F-91650 Breux Jouy (FR)
(74) Mandataire: Regimbeau
(86) Numéro de dépôt international: PCT/FR2004/002153
(87) Numéro de publication internationale: WO 2005/019844

(56) Documents cités:
- FR-A- 2 797 327
- US-A- 5 134 405
- FOURESTIE BENOIT ET AL: "A novel near-field measurement facility for random emissions" 2001 INTERNATIONAL SYMPOSIUM ON ELECTROMAGNETIC COMPATIBILITY;MONTREALM, QUE., CANADA AUG 13-17 2001, vol. 1, 2001, pages 378-382, XP002272390 IEEE Int Symp Electromagn Compat;IEEE International Symposium on Electromagnetic Compatibility 2001
- EO YUNGSEON ET AL: "A new electromagnetic interference (EMI) noise estimation technique and experimental verification of a PDP system" ASIA DISPLAY/IDW 2001;NAGOYA, JAPAN OCT 16-19 2002, 2001, pages 989-992, XP008028583 SID Conf Rec Int Display Res Conf;SID Conference Record of the International Display Research Conference 2001

## Description

L'invention concerne les dispositifs de mesure du rayonnement des antennes, et notamment les dispositifs d'évaluation du diagramme de rayonnement d'une antenne.

On connaît les chambres anéchoïques, constituées d'une enceinte apte à recevoir non seulement l'antenne à analyser, mais également un opérateur qui place, ou même maintient l'antenne pendant l'analyse.

De telles chambres anéchoïques peuvent contenir une série d'antennes d'analyse, disposées selon un cercle entourant l'antenne à analyser. Les signaux de sortie de cette série d'antennes d'analyse fournissent les données servant au tracé d'un rayonnement dans le plan où se situe ce cercle à un instant donné.

En produisant une rotation relative entre l'antenne à analyser et les antennes d'analyse, on établit donc une série de plans de rayonnement, l'ensemble des plans (cf ligne 15/ page 3) permettant ainsi un tracé en trois dimensions du diagramme de rayonnement global.

Dans le document FR 2 797 327, un diagramme de rayonnement d'un appareil sous test est établi par l'intermédiaire d'un arceau rotatif.

On connaît également de tels dispositifs pour la mesure du rayonnement des téléphones portables, dans lesquels l'utilisateur du téléphone est lui-même placé à l'intérieur du cercle formé par les différentes antennes d'analyses.

De nos jours, la caractérisation et/ou le contrôle d'une antenne ou de tout autre objet électromagnétique, émetteur ou récepteur, sont couramment confiés au détenteur d'une chambre anéchoïque ainsi équipée, qui, en retour, fournit au concepteur de l'antenne le diagramme de rayonnement demandé. ,

L'élaboration d'une antenne peut faire l'objet de multiples modifications structurelles au cours de sa conception, en fonction des rayonnements relevés dans une chambre anéchoïque d'étude.

On connaît du document US 5,134,405 une chambre anéchoïque dans laquelle est placé un appareil sous test. Un écran de visualisation des données mesurées est placé dans une pièce externe et adjacente à la chambre anéchoïque, l'écran étant séparé de la chambre anéchoïque par l'intermédiaire d'une fenêtre formant barrière électromagnétique.

Il apparaît de nos jours un souci d'obtenir des retours d'analyses de plus en plus rapides. Notamment dans le cadre d'un processus de définition d'une antenne, les analyses des différentes versions successives de l'antenne doivent être fournies avec une rapidité accrue.

Le but de l'invention est de répondre à cette attente en fournissant au concepteur d'antennes un retour d'analyses extrêmement rapide, lui permettant de procéder à des modifications de celles-ci avec une grande rapidité.

Ce but est atteint selon l'invention grâce à un aménagement selon la revendication 1. Cet aménagement pour l'étude du comportement électromagnétique d'un outil d'émission ou de réception d'ondes, comprend entre autres une chambre anéchoïque prévue pour recevoir un tel outil électromagnétique à étudier ainsi qu'une personne manipulant cet outil, comprenant en outre au moins une antenne d'analyse prévue pour capter les ondes émises ou reçues par l'outil électromagnétique à étudier, ainsi que des moyens de traitement de signaux de sortie de cette antenne d'analyse, l'aménagement comprenant en outre des moyens d'affichage d'un diagramme de rayonnement relevé pour l'outil électromagnétique à étudier, caractérisé en ce que les moyens d'affichage du diagramme de rayonnement sont placés à l'intérieur de la chambre anéchoïque, de sorte que la personne manipulant l'outil électromagnétique à étudier observe en direct l'effet de ses manipulations sur le comportement électromagnétique de cet outil. Cet outil peut être aussi placé directement sur la personne manipulant l'outil dans la chambre anéchoique (lunettes de visualisation) ou bien déporté sur une autre personne située dans la chambre anéchoique.

D'autres caractéristiques, buts et avantages de l'invention apparaîtront à la lecture de la description détaillée qui va suivre, faite en référence aux figures annexées sur lesquelles :
- la figure 1 est un schéma électrique simplifié d'un aménagement d'étude selon l'invention ;
- la figure 2 est une vue générale d'une chambre anéchoïque aménagée selon l'invention.

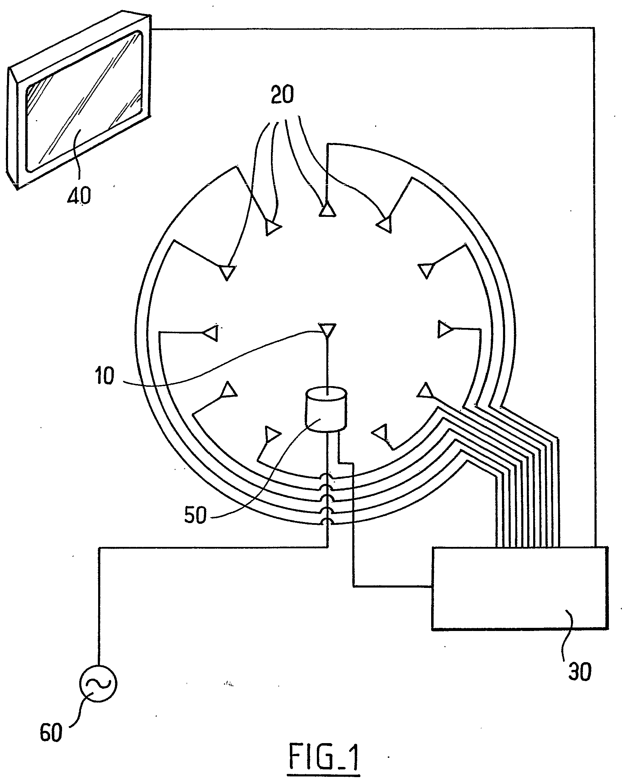

Tel qu'illustré sur le schéma simplifié de la figure 1, le dispositif d'analyse présente une structure fonctionnelle simple, basée sur une série d'organes chacun connu en lui-même.

Ainsi, le dispositif est bâti autour d'une série d'antennes d'analyses ou réseau de sondes d'analyses 20 réparties en cercle autour d'une antenne à étudier 10.

Les antennes d'analyse 20 sont reliées à un bloc de traitement 30, dont le rôle est de transformer les signaux fournis par les antennes 20 en un signal d'affichage vidéo. Ce signal vidéo est proportionnel au champ rayonné par l'antenne sous test dans la direction de l'antenne d'analyse. Ce signal vidéo est transmis sur un écran d'affichage 40 illustré en haut de la figure.

On mentionnera également que le bloc de traitement 30 est relié à un moteur rotatif 50 portant l'antenne à étudier 10, recevant de ce moteur 50 un signal de positionnement afin d'en déduire le positionnement relatif entre antenne à étudier 10 et antennes d'analyse 20.

Dans le principe de fonctionnement de l'aménagement illustré ici, le bloc de traitement 30, au fur et à mesure de la rotation du moteur 50, acquiert de manière connue une série de relevés de rayonnement selon une série de plans successifs, plans qui se répartissent en rotation autour de l'antenne à étudier 10.

L'assemblage de ces différents plans de relevés permet au bloc de traitement de fournir une visualisation en trois dimensions du diagramme de rayonnement de l'antenne à étudier, et d'afficher cette visualisation sur l'écran 40.

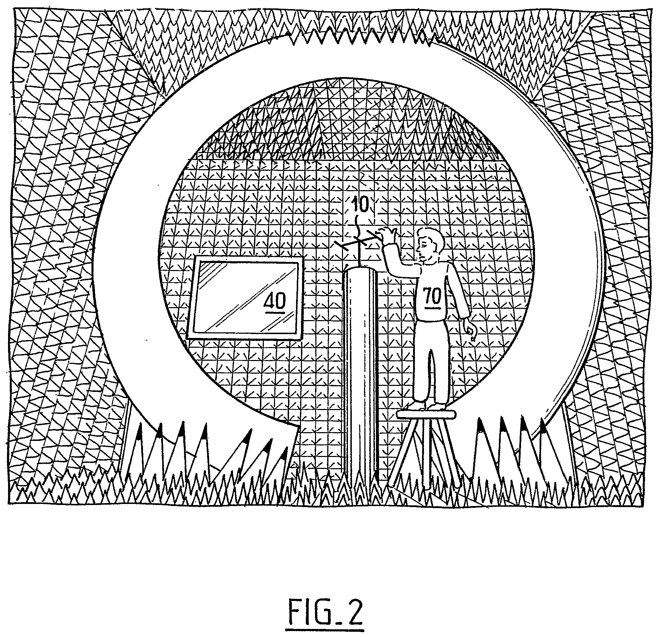

Sur la figure 1, les parois de la chambre dans laquelle sont situées les antennes, ne sont pas représentées. Les parois représentées sur la figure 2, forment une enceinte fermée et sont équipées par exemple chacune d'une multitude de picots pyramidaux dirigés vers l'intérieur.

Cette disposition élimine l'écho électromagnétique dans la chambre, qui pour cette raison est qualifiée d'anéchoïque.

Sur la figure 2, on a représenté schématiquement le positionnement d'un opérateur 70 dans la chambre dont le rôle est ici de positionner initialement l'antenne 10 et de modifier son positionnement et/ou d'ajuster des éléments de réglage après relevé de rayonnement.

Selon une disposition toute particulière, l'écran d'affichage 40, jusqu'à présent placé à l'extérieur de la chambre, typiquement dans un local extérieur uniquement dédié au traitement informatique, est ici introduit dans la chambre elle-même.

Positionné dans la chambre, l'écran 40 permet à l'opérateur d'observer en temps réel ou en léger différé le comportement de l'antenne 10 qui se trouve directement à sa portée.

L'opérateur peut alors remplir un rôle qui jusqu'à alors ne lui était pas confié, c'est à dire celui d'interpréter le comportement de l'antenne 10 (ou de tout autre outil électromagnétique) tout en manipulant cette dernière. Ce dispositif permet à l'opérateur de modifier et d'agir sur l'antenne (ou tout autre outil électromagnétique) et de visualiser le diagramme de rayonnement résultant de façon interactive.

Ainsi, des manipulations visant à améliorer le comportement de l'antenne sont rendues possibles en temps réel.

Ainsi, l'opérateur 70 peut simplement modifier la géométrie de l'antenne 10, ou encore son positionnement dans la chambre, par exemple sa hauteur ou son orientation, ou encore des paramètres de réglage et interpréter en direct les effets de ses interventions.

Il s'avère que ce rôle confié à l'opérateur, c'est à dire l'interprétation de l'effet de ses manipulations, permet une exploration beaucoup plus efficace des possibilités électromagnétiques des antennes et autres outils électromagnétiques.

Ainsi, des évolutions jusqu'alors insoupçonnées peuvent être décelées très rapidement par la manipulation expérimentale dans la chambre.

On notera qu'une variante préférée consiste à placer toutefois cet écran au plus loin possible de l'antenne, c'est à dire contre une paroi de la chambre.

Sur la figure 2, l'écran 40 est, par exemple, un écran plat à cristaux liquides ou à plasma, dont le positionnement contre une paroi verticale de la chambre s'avère ne perturber que très faiblement le rayonnement électromagnétique dans celle-ci. L'écran 40 peut aussi être un écran conventionnel pour projection optique (ordinateur + projecteur).

Plus généralement, on préférera placer la face de visionnage de l'écran, par exemple la face avant d'un moniteur plat ou à tube cathodique, dans le plan de la paroi de la chambre, évitant l'introduction d'un quelconque volume étranger dans la chambre.

Dans une variante où l'étude consiste à analyser le comportement d'un téléphone portable ou de tout autre appareil électromagnétique portatif, et où on avait l'habitude de placer l'utilisateur du téléphone dans le cercle des antennes, afin de tenir compte de l'effet du corps humain sur le rayonnement, le présent dispositif présente également un avantage certain.

Ainsi, l'utilisateur du téléphone, auquel n'était confié jusqu'alors qu'un rôle de présence organique, se voit maintenant attribuer un rôle d'observation en direct de l'effet de sa présence.

Ainsi, l'utilisateur, en variant la position de son corps ou de son téléphone par rapport à lui-même, constate en direct les effets de ces variations.

Il est ainsi rendu possible à l'utilisateur de déceler rapidement des possibilités de positionnement d'organes du téléphone qui soient particulièrement favorables à la transmission électromagnétique en présence du corps humain.

De même des modifications effectuées en direct sur l'appareil portable révèlent des possibilités d'évolutions en direct jusqu'alors insoupçonnées.

Selon une variante avantageuse pour une telle application au téléphone portable, on prévoit, outre un siège placé au centre des antennes d'analyse et dédié à recevoir l'opérateur, également un accoudoir permettant à l'opérateur de positionner son bras portant le téléphone avec précision.

Il s'avère fort avantageux de prévoir une utilisation du téléphone avec coude appuyé sur un support, afin d'éviter des mouvements du corps modifiant les conditions de base du relevé de mesures. Ce support offre l'intérêt d'effectuer des mesures successives et répétables avec des opérateurs.

De plus, un tel accoudoir est préférentiellement muni de moyens de réglage de position.

Ces moyens de réglage de position peuvent être prévus pour un réglage uniquement en hauteur, ou également pour un réglage en hauteur et en déplacement horizontal, par exemple selon un mouvement avant/arrière par rapport à l'utilisateur, ou latéral par rapport à lui.

Ces moyens de réglage sont, selon une variante la plus simple, prévus sous la forme de guides coulissants fixés, après réglage, à l'aide d'une série de vis d'immobilisation.

La présence d'un tel support de coude, ou de support d'une autre partie du bras, s'avère en outre permettre à l'opérateur de quitter le siège puis de reprendre sa position précédente de façon très proche, c'est à dire selon un positionnement relatif entre corps et téléphone qui est presque identique voire identique à la mesure précédente.

Ainsi, si une modification nécessite de quitter le siège, les rayonnements émis avant et après cette modification restent fiables puisque mesurés dans des conditions très proches.

## Revendications

1. Aménagement d'étude du comportement électromagnétique d'une antenne ou tout autre outil d'émission ou de réception d'ondes, comprenant :
- une chambre anéchoïque prévue pour recevoir un tel outil électromagnétique (10) à étudier ainsi qu'une personne manipulant cet outil (10), ladite chambre anéchoïque présentant:
o des parois réalisant une enceinte fermée, et
o une disposition permettant l'élimination d'un écho électromagnétique dans ladite chambre anéchoïque;
- au moins une antenne d'analyse (20) prévue pour capter les ondes émises ou reçues par l'outil électromagnétique à étudier (10) ;
- des moyens (30) de traitement de signaux de sortie de cette antenne d'analyse (20) ;
- des moyens d'affichage (40) d'un diagramme de rayonnement relevé pour l'outil électromagnétique à étudier (10), placés de sorte que la personne manipulant l'outil électromagnétique à étudier (10) observe en direct l'effet de ses manipulations sur le comportement électromagnétique de cet outil (10) ; **caractérisé en ce que** :
les moyens d'affichage (40) du diagramme de rayonnement sont entièrement placés à l'intérieur de la chambre anéchoïque, et
la chambre anéchoïque comprend un siège recevant la personne manipulant l'outil électromagnétique à étudier (10), et un appui réglable pour un bras de cette personne, le siège et l'appui réglable permettant un repositionnement d'ensemble de la personne avec repositionnement exact du bras, permettant ainsi plusieurs utilisations successives de l'outil électromagnétique à étudier (10) dans une même position de ce dernier par rapport au reste du corps de la personne.

2. Aménagement d'étude selon la revendication première, **caractérisé en ce qu'**il inclut un réseau d'antennes d'analyse (20), disposées selon un cercle s'étendant sensiblement autour de l'objet électromagnétique (10) à analyser.

3. Aménagement d'étude selon la revendication 2, **caractérisé en ce qu'**il inclut des moyens aptes à produire automatiquement une rotation relative entre ladite multitude d'antennes d'analyse en cercle (20) et l'outil électromagnétique à analyser (10), autour d'un axe de rotation sensiblement diamétral au cercle formé par l'ensemble d'antennes d'analyse (20).

4. Aménagement d'étude selon l'une quelconque des revendications précédentes, **caractérisé en ce que** les moyens d'affichage (40) du diagramme de rayonnement de l'objet à étudier (10) incluent un écran (40) placé sur une paroi intérieure de la chambre anéchoïque.

5. Aménagement d'étude selon l'une quelconque des revendications 1 à 3, **caractérisé en ce que** les moyens d'affichage (40) du diagramme de rayonnement de l'objet à étudier (10) incluent des lunettes de visualisation placées directement sur la personne manipulant l'outil dans la chambre anéchoique ou bien déportées sur une autre personne située dans la chambre anéchoique.

6. Aménagement d'étude selon la revendication 4, **caractérisé en ce que** l'écran (40) est constitué par la face de visionnage d'un moniteur ou bien d'un écran conventionnel pour projection optique, cette face étant sensiblement alignée avec le plan d'une des parois de la chambre.

7. Aménagement d'étude selon la revendication précédente, **caractérisé en ce que** l'écran (40) est constitué par la face de visionnage d'un moniteur plat (40), notamment un moniteur à cristaux liquides ou à plasma.

8. Aménagement d'étude selon la revendication 6, **caractérisé en ce que** l'écran (40) est un écran conventionnel pour projection optique.

9. Aménagement d'étude selon l'une quelconque des revendications précédentes, **caractérisé en ce que** l'outil électromagnétique à étudier (10) est un téléphone.

## Patentansprüche

1. Aufbau zur Untersuchung des elektromagnetischen Verhaltes einer Antenne oder jedes anderen Sende- oder Empfangswerkzeugs von Wellen, umfassend:
- einen reflexionsarmen Raum, der für den Empfang eines derartigen zu untersuchenden elektromagnetischen Werkzeugs (10) sowie einer Person, die dieses Werkzeug (10) bedient, vorgesehen ist, wobei der elektromagnetische Raum aufweist:
∘ Wände, die ein geschlossenes Behältnis bilden, und
∘ eine Anordung, welche die Entfernung eines elektromagnetischen Echos in dem reflexionsarmen Raum erlaubt;
- mindestens eine Analyseantenne (20), die zum Einfangen der von dem zu untersuchenden elektromagnetischen Werkzeug (10) gesendeten oder empfangenen Wellen vorgesehen ist;
- Verarbeitungsmittel (30) von Ausgangssignalen dieser Analyseantenne (20);
- Anzeigemittel (40) eines für das zu untersuchende elektromagnetische Werkzeug (10) ermittelten Strahlungsdiagramms, die derart platziert sind, dass die Person, welche das zu untersuchende elektromagnetische Werkzeug (10) bedient, die Wirkung ihrer Bedienungen auf das elektromagnetische Verhalten dieses Werkzeugs (10) direkt beobachtet;
**dadurch gekennzeichnet, dass**:
die Anzeigemittel (40) des Strahlungsdiagramms vollkommen im Inneren des reflexionsarmen Raums platziert sind, und
der reflexionsarme Raum einen Sitz umfasst, der die Person, welche das zu untersuchende Werkzeug (10) bedient, empfängt, und eine regulierbare Stützte für einen Arm dieser Person, wobei der Sitz und die regulierbare Stütze eine Neupositionierung der gesamten Person mit exakter Neupositionierung des Arms erlaubt, wodurch mehrere aufeinanderfolgende Verwendungen des zu untersuchenden elektromagnetischen Werkzeugs (10) in einer selben Position desselben in Bezug zum Rest des Körpers der Person ermöglicht werden.

2. Untersuchungsaufbau nach erstem Anspruch, **dadurch gekennzeichnet, dass** er ein Netz von Analyseantennen (20) einschließt, die in einem Kreis angeordnet sind, der sich etwa um das zu analysierende elektromagnetische Objekt (10) erstreckt.

3. Untersuchungsaufbau nach Anspruch 2, **dadurch gekennzeichnet, dass** er Mittel einschließt, die imstande sind, automatisch eine relative Rotation zwischen der Vielzahl von Analyseantennen im Kreis (20) und dem zu analysierenden elektromagnetischen Werkzeug (10) um eine Rotationsachse zu erzeugen, die etwa diametral zu dem von allen Analyseantennen (20) gebildeten Kreis ist.

4. Untersuchungsaufbau nach einem der vorangehenden Ansprüche, **dadurch gekennzeichnet, dass** die Anzeigemittel (40) des Strahlungsdiagramms des zu untersuchenden Objekts (10) einen Bildschirm (40) einschließen, der auf einer Innenwand des reflexionsarmen Raums platziert ist.

5. Untersuchungsaufbau nach einem der Ansprüche 1 bis 3, **dadurch gekennzeichnet, dass** die Anzeigemittel (40) des Strahlungsdiagramms des zu untersuchenden Objekts (10) Visualisierungsbrillen einschließen, die direkt auf der Person platziert sind, die das Werkzeug in dem reflexionsarmen Raum bedient, oder auch auf eine andere Person verlagert sind, die sich in dem reflexionsarmen Raum befindet.

6. Untersuchungsaufbau nach Anspruch 4, **dadurch gekennzeichnet, dass** der Bildschirm (40) von der Betrachtungsseite eines Monitors oder von einem konventionellen Bildschirm für optische Projektion gebildet ist, wobei diese Seite etwa mit der Ebene einer der Wände des Raums fluchtet.

7. Untersuchungsaufbau nach vorangehendem Anspruch, **dadurch gekennzeichnet, dass** der Bildschirm (40) von der Betrachtungsseite eines flachen Monitors (40), insbesondere eines Flüssigkristall- oder Plasmamonitors, gebildet ist.

8. Untersuchungsaufbau nach Anspruch 6, **dadurch gekennzeichnet, dass** der Bildschirm (40) ein konventioneller Bildschirm für optische Projektion ist.

9. Untersuchungsaufbau nach einem der vorangehenden Ansprüche, **dadurch gekennzeichnet, dass** das zu untersuchende elektromagnetische Werkzeug (10) ein Telefon ist.

## Claims

1. A study arrangement of the electromagnetic behaviour of an antenna or any other wave-emitting or -receiving tool, that comprises:
- an anechoic chamber designed to receive such an electromagnetic tool (10) to be studied, as well as a person handling this tool (10), said anechoic chamber having:
∘ walls forming a closed space, and
∘ an arrangement for eliminating an electromagnetic echo in said anechoic chamber;
- at least one analysis antenna (20) designed to pick-up the waves emitted or received by the electromagnetic tool to be studied (10);
- means (30) for processing output signals from this analysis antenna (20);
- means (40) for displaying a radiation diagram produced for the electromagnetic tool to be studied (10), placed so that the person operating the electromagnetic tool to be studied (10) directly observes the effect of his handling on the electromagnetic behaviour of this tool (10);
**characterized in that**:
the means (40) for displaying the radiation diagram are entirely placed inside the anechoic chamber, and
the anechoic chamber comprises a seat to accommodate the person handling the electromagnetic tool to be studied (10), and an adjustable support for one arm of this person, with the seat and the adjustable support allowing overall repositioning of the person, with exact repositioning of the arm, thus enabling several successive uses of the electromagnetic tool to be studied (10) in the same position of the latter in relation to the remainder of the body of the person.

2. The study arrangement according to claim 1, **characterised in that** it includes a network of analysis antennae (20), positioned on a circle extending substantially around the electromagnetic object (10) to be analysed.

3. The study arrangement according to claim 2, **characterised in that** it includes means that are capable of automatically producing a relative rotation between said number of analysis antennae in a circle (20) and the electromagnetic tool to be analysed (10), around an axis of rotation that is substantially diametrical to the circle formed by all the analysis antennae (20).

4. The study arrangement according to any of the preceding claims, **characterised in that** the means (40) for displaying the radiation diagram of the object to be studied (10) include a screen (40) placed on an inside wall of the anechoic chamber.

5. The study arrangement according to any of claims 1 to 3, **characterised in that** the means (40) for displaying the radiation diagram of the object to be studied (10) include viewing goggles placed directly on the person handling the tool in the anechoic chamber or fitted to another person, located in the anechoic chamber.

6. The study arrangement according to claim 4, **characterised in that** the screen (40) is composed of the viewing surface of a monitor or indeed of a conventional optical projection screen, this surface being substantially aligned with the plane of one of the walls of the chamber.

7. The study arrangement according to the preceding claim, **characterised in that** the screen (40) is composed of the viewing surface of a flat monitor (40), and in particular a liquid crystal or plasma monitor.

8. The study arrangement according to claim 6, **characterised in that** the screen (40) is a conventional optical projection screen.

9. The study arrangement according to any of the preceding claims, **characterised in that** the electromagnetic tool to be studied (10) is a telephone.
